# EUROPÄISCHE PATENTSCHRIFT

(11) **EP 2 559 094 B1**
(45) Veröffentlichungstag und Bekanntmachung des Hinweises auf die Patenterteilung: **14.05.2014**
(21) Anmeldenummer: 11707112.6
(22) Anmeldetag: 16.02.2011
(51) Int. Cl.: B60L 11/18, H01M 10/0525, G01R 31/36, H01M 10/48, H02J 7/00

(54) **BATTERIE MIT CELL-BALANCING**
BATTERY WITH CELL BALANCING
BATTERIE À ÉQUILIBRAGE D'ÉLÉMENTS

(30) Priorität: 16.04.2010 DE 102010027869
(43) Veröffentlichungstag der Anmeldung: 20.02.2013
(73) Patentinhaber: Samsung SDI Co., Ltd., Gyeonggi-do (KR); Robert Bosch GmbH, 70442 Stuttgart (DE)
(72) Erfinder: BUTZMANN, Stefan, 71717 Beilstein (DE); FINK, Holger, 70567 Stuttgart (DE)
(74) Vertreter: Bee, Joachim
(86) Internationale Anmeldenummer: PCT/EP2011/052273
(87) Internationale Veröffentlichungsnummer: WO 2011/128135

(56) Entgegenhaltungen:
- GB-A- 2 420 235
- US-A- 4 238 721
- US-A1- 2010 073 005
- US-B1- 6 624 612

## Beschreibung

Die vorliegende Erfindung betrifft eine Batterie mit einem neuartigen Cell-Balancing.

### Stand der Technik

Es zeichnet sich ab, dass in Zukunft sowohl bei stationären Anwendungen, als auch bei Fahrzeugen wie Hybrid- und Elektrofahrzeugen vermehrt Batteriesysteme zum Einsatz kommen werden. Um die für eine jeweilige Anwendung gegebenen Anforderungen an Spannung und zur Verfügung stellbare Leistung erfüllen zu können, werden eine hohe Zahl von Batteriezellen in Serie geschaltet. Da der von einer solchen Batterie bereitgestellte Strom durch alle Batteriezellen fließen muss und eine Batteriezelle nur einen begrenzten Strom leiten kann, werden oft zusätzlich Batteriezellen parallel geschaltet, um den maximalen Strom zu erhöhen.

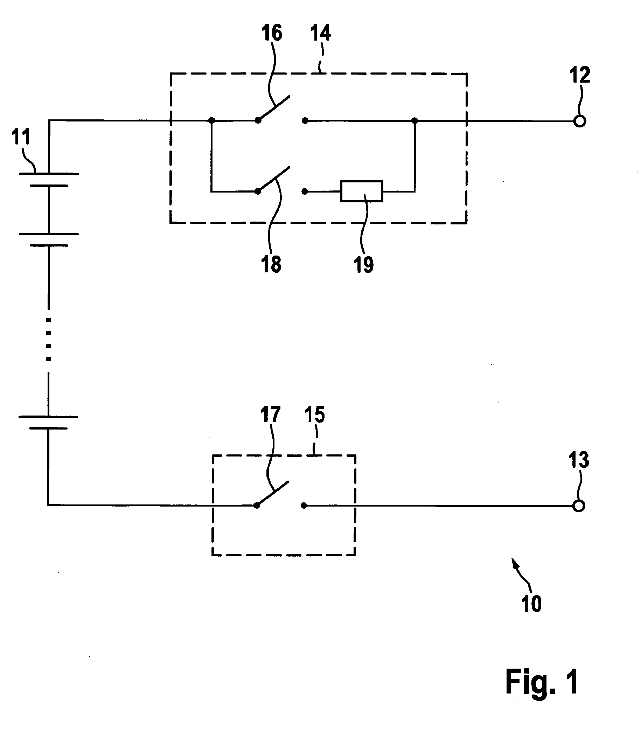

Fig. 1 zeigt eine übliche Batterie 10 in einem detaillierteren Blockschaltbild. Eine Vielzahl von Batteriezellen 11 sind in Serie sowie optional zusätzlich parallelgeschaltet, um eine für eine jeweilige Anwendung gewünschte hohe Ausgangsspannung (Serienschaltung) und Batteriekapazität (Parallelschaltung) zu erreichen. Zwischen den Pluspol der Batteriezellen und ein positives Batterieterminal 12 ist eine Lade- und Trenneinrichtung 14 geschaltet. Optional kann zusätzlich zwischen den Minuspol der Batteriezellen und ein negatives Batterieterminal 13 eine Trenneinrichtung 15 geschaltet werden. Die Trenn- und Ladeeinrichtung 14 und die Trenneinrichtung 15 umfassen jeweils ein Schütz 16 beziehungsweise 17, welche dafür vorgesehen sind, die Batteriezellen 11 von den Batterieterminals 12, 13 abzutrennen, um die Batterieterminals 12, 13 spannungsfrei zu schalten. Aufgrund der hohen Gleichspannung der seriengeschalteten Batteriezellen 11 ist andernfalls erhebliches Gefährdungspotential für Wartungspersonal oder dergleichen gegeben. In der Lade- und Trenneinrichtung 14 ist zusätzlich ein Ladeschütz 18 mit einem zu dem Ladeschütz 18 in Serie geschalteten Ladewiderstand 19 vorgesehen. Der Ladewiderstand 19 begrenzt einen Aufladestrom für den in den Gleichspannungszwischenkreis eines üblichen batteriegespeisten Antriebssystems geschalteten Pufferkondensator, wenn die Batterie an den Gleichspannungszwischenkreis angeschlossen wird. Hierzu wird zunächst das Schütz 16 offen gelassen und nur der Ladeschütz 18 geschlossen, so dass ein durch den Ladewiderstand 19 begrenzter Strom, der maximal einen Strom gleich der Batteriespannung geteilt durch den Ladewiderstand 19 erreichen kann. Erreicht die Spannung am positiven Batterieterminal 12 die Batteriespannung wenigstens näherungsweise, kann das Schütz 16 geschlossen und gegebenfalls das Ladeschütz 18 geöffnet werden. Die Schütze 16, 17 und das Ladeschütz 18 erhöhen die Kosten für eine Batterie 10 nicht unerheblich, da hohe Anforderungen an ihre Zuverlässigkeit und an die von ihnen zu führenden Ströme gestellt werden.

Die Serienschaltung einer hohen Zahl von Batteriezellen bringt neben der hohen Gesamtspannung das Problem mit sich, dass die gesamte Batterie ausfällt, wenn eine einzige Batteriezelle ausfällt, weil der Batteriestrom wegen der Serienschaltung in allen Batteriezellen fließen können muss. Ein solcher Ausfall der Batterie kann zu einem Ausfall des Gesamtsystems führen. Bei einem Elektrofahrzeug führt ein Ausfall der Antriebsbatterie zu einem sogenannten Liegenbleiber, bei anderen Vorrichtungen wie z.B. der Rotorblattverstellung bei Windkraftanlagen bei starkem Wind kann es sogar zu sicherheitsgefährdenden Situationen kommen. Daher ist eine hohe Zuverlässigkeit der Batterie vorteilhaft. Gemäß Definition bedeutet der Begriff "Zuverlässigkeit" die Fähigkeit eines Systems, für eine vorgegebene Zeit korrekt zu arbeiten.

Einen weitverbreiteten Ansatz, die Lebensdauer einer Batterie zu erhöhen, stellt das sogenannte Cell-Balancing dar. Es beruht auf der Idee, alle Batteriezellen einer Batterie möglichst gleichmäßig zu belasten, so dass eine einzelne Batteriezelle nicht vorzeitig entladen wird und so die gesamte Batterie ausfällt, obwohl in den anderen Batteriezellen noch ausreichend elektrische Energie zur Verfügung steht. Eine vorzeitig entladene Batteriezelle stellt außerdem ein erhebliches Risiko für den sicheren Betrieb dar, weil die entladene Batteriezelle anfängt, aus Sicht der verbleibenden Batteriezellen eine Last darzustellen, welche sich aufgrund des weiterhin fließenden Stromes stark erhitzen kann. Wird eine Batterie weiterbetrieben, obwohl eine Batteriezelle bereits entladen ist, droht die Zerstörung der Batteriezelle und somit ein dauerhafter Ausfall der gesamten Batterie. Im Stand der Technik sind daher verschiedene Ansätze zum Cell-Balancing zu finden, die eine Batteriezelle mit höherer Zellspannung auffinden und gegenüber den anderen Batteriezellen gezielt entladen (resistives Cell-Balancing). Da beim resistiven Cell-Balancing die durch das Cell-Balancing entnommene Energie verloren geht, wurde zudem ein induktives Cell-Balancing vorgeschlagen, bei dem die der zu entladenden Batteriezelle entnommene elektrische Energie einer anderen Batteriezelle zugeführt wird. Auch hierbei kommt es jedoch zu elektrischen Leitungsverlusten, zudem muss hoher schaltungstechnischer Aufwand unter Verwendung von Spulen betrieben werden, welche kostenintensiv und voluminös sind.

### Offenbarung der Erfindung

Erfindungsgemäß wird daher eine Batterie mit wenigstens einem Batteriemodulstrang, Sensormitteln zum Bestimmen eines Ladungszustandes einer Batteriezelle und einer Steuereinheit eingeführt. Der Batteriemodulstrang umfasst eine Mehrzahl von in Serie geschalteten Batteriemodulen, von denen jedes wenigstens eine Batteriezelle und eine Koppeleinheit besitzt. Die wenigstens eine Batteriezelle ist zwischen einen ersten Eingang und einen zweiten Eingang der Koppeleinheit geschaltet und die Koppeleinheit ausgebildet, auf ein erstes Steuersignal hin die wenigstens eine Batteriezelle zwischen ein erstes Terminal des Batteriemoduls und ein zweites Terminal des Batteriemoduls zu schalten und auf ein zweites Steuersignal hin das erste Terminal mit dem zweiten Terminal zu verbinden. Die Sensormittel sind mit der wenigstens einen Batteriezelle jedes der Batteriemodule verbindbar. Die Steuereinheit ist mit den Sensormitteln verbunden und ausgebildet, ein Batteriemodul auszuwählen, dessen wenigstens eine Batteriezelle einen niedrigsten Ladungszustand aller Batteriemodule aufweist, und das zweite Steuersignal an die Koppeleinheit des ausgewählten Batteriemoduls des Batteriemodulstranges auszugeben. Sind mehr als ein Batteriemodulstrang vorgesehen, kann die Auswählen eines Batteriemoduls für jeden Batteriemodulstrang einzeln vorgenommen werden.

Die Koppeleinheit ermöglicht es, eine oder mehrere zwischen den ersten und den zweiten Eingang der Koppeleinheit geschaltete Batteriezellen eines Batteriemoduls entweder so an den Ausgang der Koppeleinheit zu koppeln, dass die Spannung der Batteriezellen extern zur Verfügung steht, oder aber die Batteriezellen zu überbrücken, so dass eine Spannung von 0V von außen sichtbar ist. Im ersteren Fall nehmen die Batteriezellen an der Bereitstellung elektrischer Energie durch die Batterie teil, im zweiteren Fall jedoch nicht.

Die Batterie besitzt daher den Vorteil, dass Cell-Balancing allein durch die zeitliche Verteilung der tatsächlichen Belastung der Batterie auf die Batteriezellen im Betrieb möglich wird. Ein Batteriemodul mit einer oder mehreren Batteriezellen mit einem höheren Ladungszustand als Batteriezellen anderer Batteriemodule wird länger an der Bereitstellung elektrischer Energie beteiligt, als solche mit einem niedrigeren Ladungszustand, bis eine Angleichung erfolgt ist. Die den höher geladenen Batteriezellen entnommene Energie wird auf diese Weise direkt für den eigentlichen Einsatzzweck der Batterie verwendet und nicht wie beim resistiven Cell-Balancing vergeudet oder wie beim induktiven Cell-Balancing mit hohem Aufwand und immer noch verlustbehaftet zu einer anderen Batteriezelle transferiert.

Das Cell-Balancing der Erfindung kann im Extremfall für einzelne Batteriezellen betrieben werden, wenn nämlich eine Koppeleinheit auch nur eine Batteriezelle aufweist. Als schaltungstechnisch sinnvoller Kompromiss können jedoch auch Gruppen von Batteriezellen, welche an eine Koppeleinheit angeschlossen sind, gemeinsam dem Cell-Balancing unterzogen werden.

Zwar wird die Ausgangsspannung der Batterie durch abkoppeln eines Batteriemoduls gesenkt, eine niedrigere Ausgangsspannung führt jedoch in üblichen Anwendungsfällen nicht zu einem Ausfall der Gesamtanordnung und ist daher vertretbar.

Die Koppeleinheit kann einen ersten Ausgang aufweisen und ausgebildet sein, auf das erste Steuersignal hin entweder den ersten Eingang oder den zweiten Eingang mit dem Ausgang zu verbinden. Der Ausgang ist dabei mit einem der Terminals des Batteriemoduls und einer von erstem oder zweitem Eingang mit dem anderen der Terminals des Batteriemoduls verbunden. Eine solche Koppeleinheit kann mit dem Einsatz von nur zwei Schaltern, bevorzugt Halbleiterschaltern wie MOSFETs oder IGBTs, realisiert werden.

Alternativ kann die Koppeleinheit einen ersten Ausgang und einen zweiten Ausgang aufweisen und ausgebildet sein, auf das erste Steuersignal hin den ersten Eingang mit dem ersten Ausgang und den zweiten Eingang mit dem zweiten Ausgang zu verbinden. Dabei ist die Koppeleinheit außerdem ausgebildet, auf das zweite Steuersignal hin den ersten Eingang vom ersten Ausgang und den zweiten Eingang vom zweiten Ausgang abzutrennen und den ersten Ausgang mit dem zweiten Ausgang zu verbinden. Diese Ausführungsform benötigt einen etwas höheren Schaltungsaufwand (gewöhnlich drei Schalter), koppelt aber die Batteriezellen des Batteriemoduls an dessen beiden Polen ab, so dass bei einer drohenden Tiefentladung oder einer Beschädigung eines Batteriemoduls dessen Batteriezellen spannungsfrei geschaltet und so im fortwährenden Betrieb der Gesamtanordnung gefahrlos ausgetauscht werden können.

Die Sensormittel können eine Spannungsmesseinheit umfassen, welche ausgebildet ist, eine Zellspannung einer Batteriezelle oder eine Spannung eines Batteriemoduls zu bestimmen. Die Zellspannung einer Batteriezelle beziehungsweise die Spannung eines Batteriemoduls ist der wichtigste Parameter bei der Bestimmung des Ladungszustandes einer Batteriezelle beziehungsweise eines Batteriemoduls. Besonders genaue Rückschlüsse sind möglich, wenn auch der zeitliche Verlauf der Zellspannung beziehungsweise Batteriemodulspannung erfasst und ausgewertet wird.

Zusätzlich können die Sensormittel eine Temperaturmesseinheit umfassen, welche ausgebildet ist, eine Zelltemperatur der Batteriezelle oder eine Temperatur des Batteriemoduls zu bestimmen. Sowohl die Zellspannung als auch die Kapazität einer Batteriezelle sind temperaturabhängig, weshalb eine zusätzliche Erfassung der Temperatur einer Batteriezelle oder des Batteriemoduls eine genauere Bestimmung des Ladungszustandes erlaubt.

Die Sensormittel können außerdem eine Strommesseinheit umfassen, welche ausgebildet ist, einen Strom des wenigstens einen Batteriemodulstranges zu bestimmen. Bei einer höheren Belastung wird die Zellspannung einer Batteriezelle beziehungsweise die Spannung eines Batteriemoduls bei gleichem Ladungszustand niedriger sein als bei einer geringeren Belastung. Daher kann die Bestimmung des Ladungszustandes genauer und bei wechselnden Belastungen vorgenommen werden, wenn zusätzlich der Strom des Batteriemodulstranges bestimmt wird.

Besonders bevorzugt weist die Batterie genau drei Batteriemodulstränge auf. Dies erlaubt den Betrieb von dreiphasigen Antriebsmotoren aus einer Batterie.

Die wenigstens eine Batteriezelle ist bevorzugt eine Lithium-Ionen-Batteriezelle. Lithium-Ionen-Batteriezellen besitzen die Vorteile einer hohen Zellspannung und einer hohen Kapazität in einem gegebenen Volumen.

Ein zweiter Erfindungsaspekt betrifft ein Kraftfahrzeug mit einem elektrischen Antriebsmotor zum Antreiben des Kraftfahrzeuges und einer mit dem elektrischen Antriebsmotor verbundenen Batterie gemäß dem vorhergehenden Erfindungsaspekt.

### Zeichnungen

Ausführungsbeispiele der Erfindung werden anhand der Zeichnungen und der nachfolgenden Beschreibung näher erläutert, wobei gleiche Bezugszeichen gleiche oder funktional gleichartige Komponenten bezeichnen. Es zeigen:
Figur 1 ein Blockschaltbild einer Batterie gemäß dem Stand der Technik,
Figur 2 eine erste Ausführung einer Koppeleinheit zum Einsatz in der erfindungsgemäßen Batterie,
Figur 3 eine mögliche schaltungstechnische Umsetzung der ersten Ausführungsform der Koppeleinheit,
Figuren 4A und 4B zwei Ausführungsformen eines Batteriemoduls mit der ersten Ausführungsform der Koppeleinheit,
Figur 5 eine zweite Ausführungsform einer Koppeleinheit zum Einsatz in der erfindungsgemäßen Batterie,
Figur 6 eine mögliche schaltungstechnische Umsetzung der zweiten Ausführungsform der Koppeleinheit,
Figur 7 eine Ausführungsform eines Batteriemoduls mit der zweiten Ausführungsform der Koppeleinheit, und
Figur 8 eine Ausführungsform der erfindungsgemäßen Batterie.

### Ausführungsformen der Erfindung

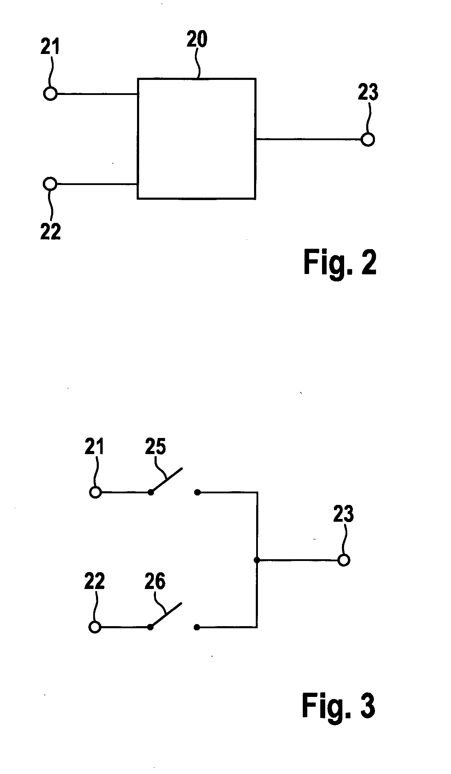

Figur 2 zeigt eine erste Ausführung einer Koppeleinheit 20 zum Einsatz in der erfindungsgemäßen Batterie. Die Koppeleinheit 20 besitzt zwei Eingänge 21 und 22 sowie einen Ausgang 23 und ausgebildet, einen der Eingänge 21 oder 22 mit dem Ausgang 23 zu verbinden und den anderen abzukoppeln. Bei bestimmten Ausführungsformen der Koppeleinheit kann diese außerdem ausgebildet sein, beide Eingänge 21, 22 vom Ausgang 23 abzutrennen. Nicht vorgesehen ist jedoch, sowohl den Eingang 21 als auch den Eingang 22 mit dem Ausgang 23 zu verbinden, was zu einem Kurzschluss der beiden Eingänge 21, 22 führen würde.

Figur 3 zeigt eine mögliche schaltungstechnische Umsetzung der ersten Ausführungsform der Koppeleinheit 20, bei der ein erster und ein zweiter Schalter 25 beziehungsweise 26 vorgesehen sind. Jeder der Schalter ist zwischen einen der Eingänge 21 beziehungsweise 22 und den Ausgang 23 geschaltet. Diese Ausführungsform bietet den Vorteil, dass auch beide Eingänge 21, 22 vom Ausgang 23 abgekoppelt werden können, so dass der Ausgang 23 hochohmig wird, was beispielsweise im Fall einer Reparatur oder Wartung nützlich sein kann. Zudem können die Schalter 25, 26 einfach als Halbleiterschalter wie z.B. MOSFETs oder IGBTs verwirklicht werden. Halbleiterschalter haben den Vorteil eines günstigen Preises und einer hohen Schaltgeschwindigkeit, so dass die Koppeleinheit 30 innerhalb einer geringen Zeit auf eine Steuersignal beziehungsweise eine Änderung des Steuersignales reagieren kann und hohe Umschaltraten erreichbar sind.

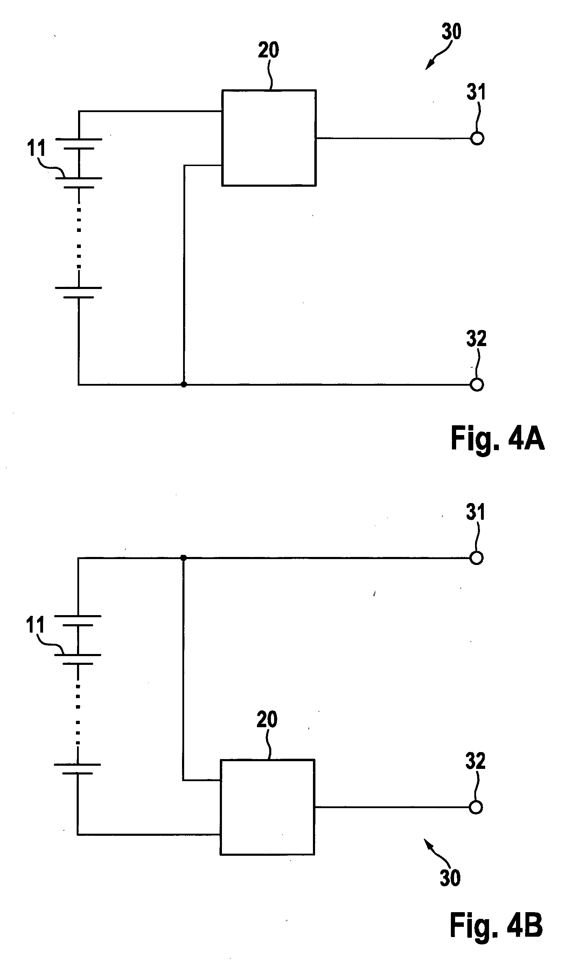

Die Figuren 4A und 4B zeigen zwei Ausführungsformen eines Batteriemoduls 30 mit der ersten Ausführungsform der Koppeleinheit 20. Eine Mehrzahl von Batteriezellen 11 sind zwischen die Eingänge der Koppeleinheit 20 in Serie geschaltet. Die Erfindung ist jedoch nicht auf eine solche Serienschaltung von Batteriezellen 11 beschränkt, es kann auch nur eine einzelne Batteriezelle 11 vorgesehen sein oder aber eine Parallelschaltung oder gemischt-seriell-parallele Schaltung von Batteriezellen 11. Im Beispiel der Figur 4A sind der Ausgang der Koppeleinheit 20 mit einem ersten Terminal 31 und der negative Pol der Batteriezellen 11 mit einem zweiten Terminal 32 verbunden. Es ist jedoch eine beinahe spiegelbildliche Anordnung wie in Figur 4B möglich, bei der der positive Pol der Batteriezellen 11 mit dem ersten Terminal 31 und der Ausgang der Koppeleinheit 20 mit dem zweiten Terminal 32 verbunden sind.

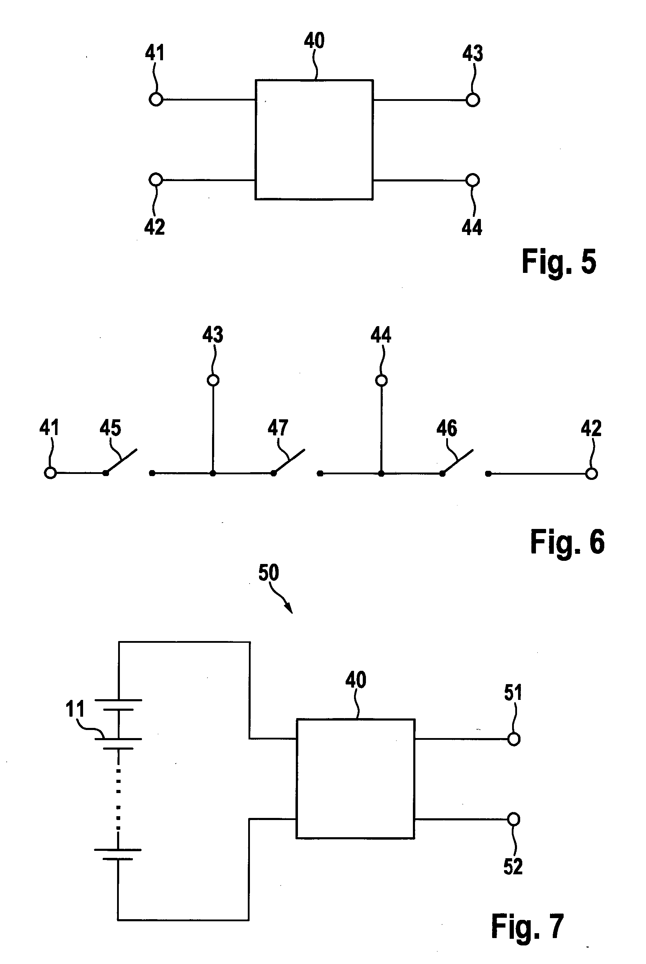

Figur 5 zeigt eine zweite Ausführungsform einer Koppeleinheit 40 zum Einsatz in der erfindungsgemäßen Batterie. Die Koppeleinheit 40 besitzt zwei Eingänge 41 und 42 sowie zwei Ausgänge 43 und 44. Sie ist ausgebildet, entweder den ersten Eingang 41 mit dem ersten Ausgang 43 sowie den zweiten Eingang 42 mit dem zweiten Ausgang 44 zu verbinden (und den ersten Ausgang 43 vom zweiten Ausgang 44 abzukoppeln) oder aber den ersten Ausgang 43 mit dem zweiten Ausgang 44 zu verbinden (und dabei die Eingänge 41 und 42 abzukoppeln). Bei bestimmten Ausführungsformen der Koppeleinheit kann diese außerdem ausgebildet sein, beide Eingänge 41, 42 von den Ausgängen 43, 44 abzutrennen und auch den ersten Ausgang 43 vom zweiten Ausgang 44 abzukoppeln. Nicht vorgesehen ist jedoch, sowohl den ersten Eingang 41 mit dem zweiten Eingang 42 zu verbinden.

Figur 6 zeigt eine mögliche schaltungstechnische Umsetzung der zweiten Ausführungsform der Koppeleinheit 40, bei der ein erster, ein zweiter und ein dritter Schalter 45, 46 und 47 vorgesehen sind. Der erste Schalter 45 ist zwischen den ersten Eingang 41 und den ersten Ausgang 43 geschaltet, der zweite Schalter 46 ist zwischen den zweiten Eingang 42 und den zweiten Ausgang 44 und der dritte Schalter 47 zwischen den ersten Ausgang 43 und den zweiten Ausgang 44 geschaltet. Diese Ausführungsform bietet ebenfalls den Vorteil, dass die Schalter 45, 46 und 47 einfach als Halbleiterschalter wie z.B. MOSFETs oder IGBTs verwirklicht werden können. Halbleiterschalter haben den Vorteil eines günstigen Preises und einer hohen Schaltgeschwindigkeit, so dass die Koppeleinheit 40 innerhalb einer geringen Zeit auf eine Steuersignal beziehungsweise eine Änderung des Steuersignales reagieren kann und hohe Umschaltraten erreichbar sind.

Die Figur 7 zeigt eine Ausführungsform eines Batteriemoduls 50 mit der zweiten Ausführungsform der Koppeleinheit 40. Eine Mehrzahl von Batteriezellen 11 sind zwischen die Eingänge einer Koppeleinheit 40 in Serie geschaltet. Auch diese Ausführungsform des Batteriemoduls 50 ist nicht auf eine solche Serienschaltung von Batteriezellen 11 beschränkt, es kann wiederum auch nur eine einzelne Batteriezelle 11 vorgesehen sein oder aber eine Parallelschaltung oder gemischtseriell-parallele Schaltung von Batteriezellen 11. Der erste Ausgang der Koppeleinheit 40 ist mit einem ersten Terminal 51 und der zweite Ausgang der Koppeleinheit 40 mit einem zweiten Terminal 52 verbunden. Das Batteriemodul 50 bietet gegenüber dem Batteriemodul 30 der Figuren 4A und 4B den Vorteil, dass die Batteriezellen 11 durch die Koppeleinheit 40 von der restlichen Batterie beidseitig abgekoppelt werden können, was einen gefahrlosen Austausch im laufenden Betrieb ermöglicht, da an keinem Pol der Batteriezellen 11 die gefährliche hohe Summenspannung der restlichen Batteriemodule der Batterie anliegt.

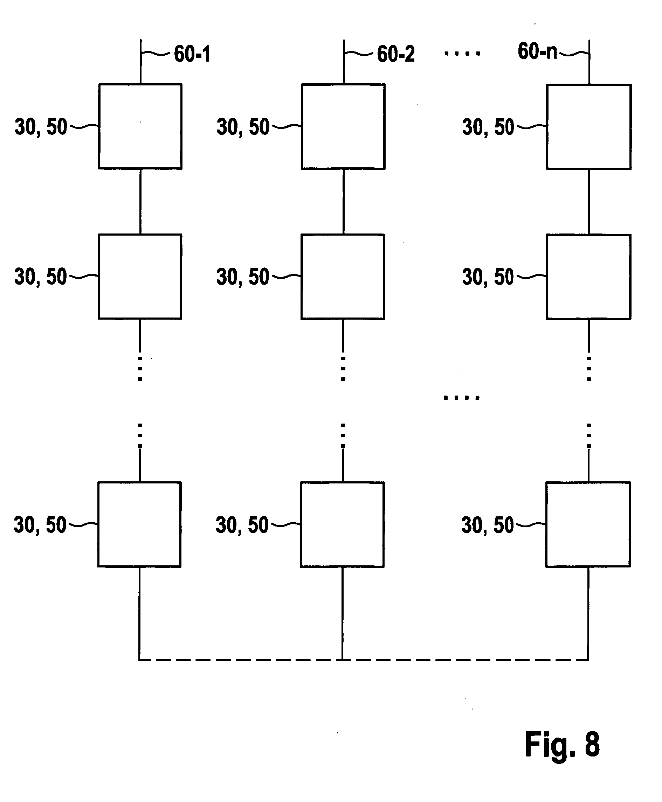

Figur 8 zeigt eine Ausführungsform der erfindungsgemäßen Batterie, welche über n Batteriemodulstränge 60-1 bis 60-n verfügt. Jeder Batteriemodulstrang 60-1 bis 60-n weist eine Mehrzahl von Batteriemodulen 30 oder 50 auf, wobei vorzugsweise jeder Batteriemodulstrang 60-1 bis 60-n dieselbe Anzahl von Batteriemodulen 30 oder 50 und jedes Batteriemodul 30, 50 dieselbe Anzahl von Batteriezellen 11 in identischer Weise verschaltet enthält. Ein Pol eines jeden Batteriemodulstranges 60 kann mit einem entsprechenden Pol der anderen Batteriemodulstränge 60 verbunden sein, was durch eine gestrichelte Linie in Figur 8 angedeutet ist. Generell kann ein Batteriemodulstrang 60 jede Zahl von Batteriemodulen 30, 50 größer 1 und eine Batterie jede Zahl von Batteriemodulsträngen 60 enthalten. Auch können an den Polen der Batteriemodulstränge 60 zusätzlich Lade- und Trenneinrichtungen und Trenneinrichtungen wie bei Figur 1 beschrieben vorgesehen sein, wenn Sicherheitsbestimmungen dies erfordern. Allerdings sind solche Trenneinrichtungen erfindungsgemäß nicht notwendig, weil eine Abkopplung der Batteriezellen 11 von den Batterieanschlüssen durch die in den Batteriemodulen 30, 50 enthaltenen Koppeleinheiten 20, 40 erfolgen kann.

Wie bereits beschrieben, erlaubt die erfindungsgemäße Batterie ein Cell-Balancing, bei dem die Batteriezellen eines Batteriemoduls mit einem vergleichsweise höheren Ladungszustand über einen längeren Zeitraum für die Bereitstellung elektrischer Energie herangezogen wird als die Batteriezellen eines Batteriemoduls mit einem vergleichsweise niedrigeren Ladungszustand. Dadurch wird sämtliche in der Batterie gespeicherte elektrische Energie tatsächlich für die batteriebetriebene Anwendung zur Verfügung gestellt, statt sie nur im Rahmen eines normalen Cell-Balancings entweder zu vergeuden oder aufwendig und verlustbehaftet umzuverteilen.

Ein weiterer Vorteil der erfindungsgemäßen Batterie ist, dass sie sehr einfach modular aus einzelnen Batteriemodulen mit integrierter Koppeleinheit aufgebaut werden kann. Dadurch wird die Verwendung von Gleichteilen (Baukastenprinzip) möglich.

## Patentansprüche

1. Eine Batterie mit wenigstens einem Batteriemodulstrang (60), Sensormitteln zum Bestimmen eines Ladungszustandes einer Batteriezelle (11) und einer Steuereinheit,
wobei der wenigstens eine Batteriemodulstrang (60) eine Mehrzahl von in Serie geschalteten Batteriemodulen (30, 50) umfasst,
wobei jedes Batteriemodul (30, 50) wenigstens eine Batteriezelle (11) und eine Koppeleinheit (20, 40) umfasst,
wobei die wenigstens eine Batteriezelle (11) zwischen einen ersten Eingang (21, 41) und einen zweiten Eingang (22, 42) der Koppeleinheit (20, 40) geschaltet und die Koppeleinheit (20, 40) ausgebildet ist, auf ein erstes Steuersignal hin die wenigstens eine Batteriezelle (11) zwischen ein erstes Terminal (31, 51) des Batteriemoduls (30, 50) und ein zweites Terminal (32, 52) des Batteriemoduls (30, 50) zu schalten und auf ein zweites Steuersignal hin das erste Terminal (31, 51) mit dem zweiten Terminal (32, 52) zu verbinden,
wobei die Sensormittel mit der wenigstens einen Batteriezelle (11) jedes der Batteriemodule (30, 50) verbindbar sind, und
wobei die Steuereinheit mit den Sensormitteln verbunden und ausgebildet ist, ein Batteriemodul (30, 50) auszuwählen, dessen wenigstens eine Batteriezelle (11) einen niedrigsten Ladungszustand aller Batteriemodule (30, 50) des Batteriemodulstranges (60) aufweist, und das zweite Steuersignal an die Koppeleinheit (20 , 40) des ausgewählten Batteriemoduls (30, 50) auszugeben.

2. Die Batterie gemäß Anspruch 1, bei der die Koppeleinheit (20) einen ersten Ausgang (23) aufweist und ausgebildet ist, auf das erste Steuersignal hin entweder den ersten Eingang (21) oder den zweiten Eingang (22) mit dem ersten Ausgang (23) zu verbinden.

3. Die Batterie gemäß Anspruch 1, bei der die Koppeleinheit (40) einen ersten Ausgang (43) und einen zweiten Ausgang (44) aufweist und ausgebildet ist, auf das erste Steuersignal hin den ersten Eingang (41) mit dem ersten Ausgang (43) und den zweiten Eingang (42) mit dem zweiten Ausgang (44) zu verbinden und auf das zweite Steuersignal hin den ersten Eingang (41) vom ersten Ausgang (43) und den zweiten Eingang (42) vom zweiten Ausgang (44) abzutrennen und den ersten Ausgang (43) mit dem zweiten Ausgang (44) zu verbinden.

4. Die Batterie gemäß einem der vorhergehenden Ansprüche, bei der die Sensormittel eine Spannungsmesseinheit umfassen, welche ausgebildet ist, eine Zellspannung einer Batteriezelle (11) oder eine Spannung eines Batteriemoduls (30, 50) zu bestimmen.

5. Die Batterie gemäß Anspruch 4, bei der die Sensormittel außerdem eine Temperaturmesseinheit umfassen, welche ausgebildet ist, eine Zelltemperatur der Batteriezelle (11) oder eine Temperatur des Batteriemoduls (30, 50) zu bestimmen.

6. Die Batterie gemäß einem der Ansprüche 4 oder 5, bei der die Sensormittel außerdem eine Strommesseinheit umfassen, welche ausgebildet ist, einen Strom des wenigstens einen Batteriemodulstranges (60) zu bestimmen.

7. Die Batterie gemäß einem der vorhergehenden Ansprüche, mit genau drei Batteriemodulsträngen (60).

8. Die Batterie gemäß einem der vorhergehenden Ansprüche, bei der die wenigstens eine Batteriezelle (11) eine Lithium-Ionen-Batteriezelle ist.

9. Ein Kraftfahrzeug mit einem elektrischen Antriebsmotor zum Antreiben des Kraftfahrzeuges und einer mit dem elektrischen Antriebsmotor verbundenen Batterie gemäß einem der vorhergehenden Ansprüche.

## Claims

1. Battery having at least one battery module line (60), sensor means for determining a state of charge of a battery cell (11) and a control unit,
wherein the at least one battery module line (60) comprises a multiplicity of battery modules (30, 50) which are connected in series,
wherein each battery module (30, 50) comprises at least one battery cell (11) and a coupling unit (20, 40),
wherein the at least one battery cell (11) is connected between a first input (21, 41) and a second input (22, 42) of the coupling unit (20, 40), and the coupling unit (20, 40) is designed to connect the at least one battery cell (11) between a first terminal (31, 51) of the battery module (30, 50) and a second terminal (32, 52) of the battery module (30, 50) in response to a first control signal and to connect the first terminal (31, 51) to the second terminal (32, 52) in response to a second control signal,
wherein the sensor means can be connected to the at least one battery cell (11) of each of the battery modules (30, 50), and
wherein the control unit is connected to the sensor means and is designed to select a battery module (30, 50) whose at least one battery cell (11) has a lowest state of charge of all the battery modules (30, 50) of the battery module line (60), and to output the second control signal to the coupling unit (20, 40) of the selected battery module (30, 50).

2. Battery according to Claim 1, in which the coupling unit (20) has a first output (23) and is designed to connect either the first input (21) or the second input (22) to the first output (23) in response to the first control signal.

3. Battery according to Claim 1, in which the coupling unit (40) has a first output (43) and a second output (44) and is designed to connect the first input (41) to the first output (43) and the second input (42) to the second output (44) in response to the first control signal, and to disconnect the first input (41) from the first output (43) and the second input (42) from the second output (44) in response to the second control signal, and to connect the first output (43) to the second output (44).

4. Battery according to one of the preceding claims, in which the sensor means comprise a voltage measuring unit which is designed to determine a cell voltage of a battery cell (11) or a voltage of a battery module (30, 50).

5. Battery according to Claim 4, in which the sensor means also comprise a temperature measuring unit which is designed to determine a cell temperature of the battery cell (11) or a temperature of the battery module (30, 50).

6. Battery according to one of Claims 4 or 5, in which the sensor means also comprise a current measuring unit which is designed to determine a current of the at least one battery module line (60).

7. Battery according to one of the preceding claims with precisely three battery module lines (60).

8. Battery according to one of the preceding claims, in which the at least one battery cell (11) is a lithium-ion battery cell.

9. Motor vehicle having an electric drive motor for driving the motor vehicle and a battery connected to the electric drive motor, according to one of the preceding claims.

## Revendications

1. Batterie comprenant au moins une série de modules de batterie (60), des moyens de capteurs pour déterminer un état de charge d'une cellule de batterie (11) et une unité de commande,
l'au moins une série de modules de batterie (60) comprenant une pluralité de modules de batterie (30, 50) montés en série,
chaque module de batterie (30, 50) comprenant au moins une cellule de batterie (11) et une unité d'accouplement (20, 40),
l'au moins une cellule de batterie (11) étant branchée entre une première entrée (21, 41) et une deuxième entrée (22, 42) de l'unité d'accouplement (20, 40) et l'unité d'accouplement (20, 40) étant réalisée de manière à commuter, en réponse à un premier signal de commande, l'au moins une cellule de batterie (11) entre une première borne (31, 51) du module de batterie (30, 50) et une deuxième borne (32, 52) du module de batterie (30, 50) et à connecter, en réponse à un deuxième signal de commande, la première borne (31, 51) à la deuxième borne (32, 52),
les moyens de capteurs pouvant être connectés à l'au moins une cellule de batterie (11) de chaque module de batterie (30, 50), et
l'unité de commande étant connectée aux moyens de capteurs et étant réalisée de manière à sélectionner un module de batterie (30, 50) dont au moins une cellule de batterie (11) présente un état de charge le plus faible de tous les modules de batterie (30, 50) de la série de modules de batterie (60), et à envoyer le deuxième signal de commande à l'unité d'accouplement (20, 40) du module de batterie sélectionné (30, 50).

2. Batterie selon la revendication 1, dans laquelle l'unité d'accouplement (20) présente une première sortie (23), et est réalisée de manière à connecter, en réponse au premier signal de commande, soit la première entrée (21) soit la deuxième entrée (22) à la première sortie (23).

3. Batterie selon la revendication 1, dans laquelle l'unité d'accouplement (40) présente une première sortie (43) et une deuxième sortie (44) et est réalisée, en réponse au premier signal de commande, pour connecter la première entrée (41) à la première sortie (43) et la deuxième entrée (42) à la deuxième sortie (44) et, en réponse au deuxième signal de commande, pour séparer la première entrée (41) de la première sortie (43) et la deuxième entrée (42) de la deuxième sortie (44) et pour connecter la première sortie (43) à la deuxième sortie (44).

4. Batterie selon l'une quelconque des revendications précédentes, dans laquelle les moyens de capteurs comprennent une unité de mesure de tension qui est réalisée de manière à déterminer une tension de cellule d'une cellule de batterie (11) ou une tension d'un module de batterie (30, 50).

5. Batterie selon la revendication 4, dans laquelle les moyens de capteurs comprennent en outre une unité de mesure de température qui est réalisée de manière à déterminer une température de cellule de la cellule de batterie (11) ou une température du module de batterie (30, 50).

6. Batterie selon l'une quelconque des revendications 4 ou 5, dans laquelle les moyens de capteurs comprennent en outre une unité de mesure de courant qui est réalisée pour déterminer un courant de l'au moins une série de modules de batterie (60).

7. Batterie selon l'une quelconque des revendications précédentes, comprenant exactement trois séries de modules de batterie (60).

8. Batterie selon l'une quelconque des revendications précédentes, dans laquelle l'au moins une cellule de batterie (11) est une cellule de batterie lithium-ion.

9. Véhicule automobile comprenant un moteur d'entraînement électrique pour entraîner le véhicule automobile et une batterie connectée au moteur d'entraînement électrique selon l'une quelconque des revendications précédentes.
